# EUROPÄISCHE PATENTSCHRIFT

(11) **EP 1 350 287 B1**
(45) Veröffentlichungstag und Bekanntmachung des Hinweises auf die Patenterteilung: **08.10.2008**
(21) Anmeldenummer: 02712812.3
(22) Anmeldetag: 11.01.2002
(51) Int. Cl.: H01R 43/02

(54) **VERFAHREN UND VORRICHTUNG ZUM VERBINDEN VON LEITERN**
METHOD AND DEVICE FOR CONNECTING CONDUCTORS
PROCEDE ET DISPOSITIF SERVANT A CONNECTER DES CONDUCTEURS

(30) Priorität: 12.01.2001 DE 10101236
(43) Veröffentlichungstag der Anmeldung: 08.10.2003
(73) Patentinhaber: SCHUNK Ultraschalltechnik GmbH, D-35435 Wettenberg (DE)
(72) Erfinder: STEINER, Ernst, 35452 Heuchelheim (DE); STROH, Dieter, 35435 Wettenberg (DE); DIETERLE, Horst, 35096 Niederweimar (DE)
(74) Vertreter: Stoffregen, Hans-Herbert
(86) Internationale Anmeldenummer: PCT/EP2002/000198
(87) Internationale Veröffentlichungsnummer: WO 2002/061895

(56) Entgegenhaltungen:
- EP-A- 1 014 515

## Beschreibung

Die Erfindung bezieht sich auf ein Verfahren zum Verbinden wie Verschweißen von von Außenisolationen umgebenen elektrischen Leitern von sich überlappenden Flachleitern mittels Ultraschallschwingungen erzeugender Sonotrode und dieser zugeordneter Gegenelektrode, wobei auf einer zwischen Sonotrode und Gegenelektrode verlaufender Fläche eines Trägers die zu verbindenden Leiter angeordnet werden. Ferner bezieht sich die Erfindung auf eine Vorrichtung zum Verbinden von von Außenisolationen umgebenen elektrischen Leitern von sich überlappenden Flachleitern mittels Ultraschallschwingungen erzeugender Sonotrode und dieser zugeordneter Gegenelektrode, wobei auf einer zwischen der Sonotrode und der Gegenelektrode verlaufenden Fläche eines Trägers die zu verschweißenden Leiter anordbar sind.

Insbesondere bei Kraftfahrzeugen gelangen in verstärktem Umfang Flachleiter (FPC = Flexible Printed Cable; FLC =. Flexible Laminated Cable; FFC = Flexible Flat Cable) zur Bordnetzverdrahtung zum Einsatz. Hohe Flexibilität, geringer Platzbedarf sowie Gewichtsersparnis zeichnen entsprechende auch als Leiterfolien bezeichnete Flachleiter aus. Werden Flachleiter untereinander verbunden, so muss sichergestellt sein, dass die Kontaktstellen mechanischen Belastungen standhalten, um die erforderliche Strom- bzw. Signalleitung zu gewährleisten. Dabei ist es häufig erforderlich, dass auf engstem Raum elektrische Leiter von sich überlappenden Flachleitern elektrisch leitend verbunden werden müssen. Da Flachleiter im zunehmenden Umfang Kabelbäume ersetzen, muss des Weiteren die Möglichkeit gegeben sein, eine Vielzahl von Flachleitern elektrisch zu verknüpfen. Hierzu müssen diese zuvor in einer Ebene zueinander ausgerichtet werden.

Aus der EP 1 014 515 A1 sowie der EP 0 191 175 B1 ist es bekannt, Flachleiter untereinander mittels Ultraschallschweißens zu verbinden.

Der vorliegenden Erfindung liegt das Problem zugrunde, ein Verfahren und eine Vorrichtung der eingangs genannten Art so weiterzubilden, dass im erforderlichen Umfang überaus präzise elektrische Leiter von sich überlappenden Flachleitern verbunden werden können, auch dann, wenn eine Vielzahl von Flachleitern in einer Ebene zueinander ausgerichtet sind.

Erfindungsgemäß wird das Problem verfahrensmäßig im Wesentlichen dadurch gelöst, dass die Flachleiter in verschiedenen Bereichen nacheinander verschweißt werden, dass die Sonotrode und die verschiedenen Bereiche nacheinander aufeinander ausgerichtet werden und dass als Träger ein solcher verwendet wird, der zumindest bereichsweise als Gegenelektrode ausgebildet ist oder der in den Bereichen, in denen die Flachleiter verschweißt werden, Durchbrechungen aufweist, auf die im erforderlichen Umfang die Gegenelektrode ausgerichtet wird oder die im erforderlichen Umfang auf die Gegenelektrode ausgerichtet werden. Dabei wird insbesondere die Sonotrode zu dem Träger verfahren. Ein Verstellen des Trägers zu der Sonotrode oder ein beidseitiges Verstellen zueinander ist gleichfalls möglich.

Unabhängig hiervon sollte als Sonotrode eine solche verwendet werden, die als ein Torsionsschwinger, ein als Wippe gelagerter Längsschwinger, ein parallel geführter Längsschwinger oder als ein Biegeschwinger ausgebildet ist.

Insbesondere zeichnet sich die Erfindung jedoch dadurch aus, dass die Sonotrode zur Erzeugung der zum Verbinden wie Verschweißen der Leiter erforderlichen Ultraschallenergie in Torsionsschwingung versetzt wird, wobei die Sonotrode mit ihrer Längsachse senkrecht oder geneigt zu der Fläche des Trägers verläuft, auf der die zu verbindenden wie zu verschweißenden Flachleiter angeordnet werden.

Erfindungsgemäß wird eine Ultraschallschweißvorrichtung insbesondere mit einem Torsionsschwinger, einem als Wippe ausgebildeten Längsschwinger, einem parallel geführten Längsschwinger, einem Biegeschwinger oder einer sonstigen von Ultraschallschweißvorrichtungen bekannten Sonotrodenausbildung benutzt, um die erforderliche Ultraschallenergie zu erzeugen. Die Sonotrode bzw. deren Schweißfläche kann sodann auf die zu verschweißenden Leiter ausgerichtet werden. Als Gegenelektrode kann der Träger selbst genutzt werden, auf dem die Flachleiter positionsgenau zueinander ausgerichtet angeordnet werden. Es besteht jedoch auch die Möglichkeit, den Träger mit Durchbrechungen zu versehen, um im gewünschten Umfang auf diese sodann eine Gegenelektrode auszurichten und die zu verbindenden Leiter abzustützen, wenn ein Verschweißen erfolgen soll.

Des Weiteren kann bei der Verwendung eines Torsionsschwingers als die die Ultraschallenergie abgebende Sonotrode ein Verbinden der Leiter sowohl durch rein mechanisches Verbinden als auch durch Verschweißen erfolgen. Ersteres wird dadurch ermöglicht, dass der Sonotrodenkopf stirnflächenseitig spitz zulaufend ausgebildet ist, so dass mittels der Spitze die zu verbindenden Leiter durchstochen werden können, wodurch diese gleichsinnig verformt und insbesondere formschlüssig mechanisch miteinander verbunden werden. Zusätzlich kann ein Verschweißen der so durchstochenen Leiter durch Kontaktieren von Schweißflächen der Sonotrode mit den Leitern und deren Abstützen auf einer Gegenelektrode, erfolgen. Hierzu kann die Gegenelektrode entsprechend der durch das Durchstechen erzeugten Geometrie der mechanisch verbundenen Leiter eine trichterförmige Vertiefung aufweisen, entlang deren Begrenzungsflächen sich die durchstochenen Leiter erstrecken.

Um ein präzises Verschweißen der Leiter in vorgegebenen Bereichen zu ermöglichen, sieht eine Weiterbildung der Erfindung vor, dass die Sonotrode auf die verschweißten Leiter unter visueller Kontrolle mit Hilfe eines optischen Systems ausgerichtet wird. Dabei kann die visuelle Kontrolle über eine Bildverarbeitung durchgeführt werden. Hierdurch ist ein automatisches Anfahren der Sonotrode auf den Bereich der Leiter möglich, in dem das Schweißen durchgeführt werden soll.

Es besteht jedoch auch oder ergänzend die Möglichkeit, den zu verschweißenden Bereich optisch zum Beispiel mittels eines Laserstrahls zu kennzeichnen, um sodann die Sonotrode automatisch oder von Hand zuzuführen.

Auch zeichnet sich die Erfindung dadurch aus, dass mittels der Sonotrode nicht nur ein Verschweißen der Leiter, also von Metall erfolgt, sondern dass auch die sich überlappenden Außenisolationen untereinander durch Kunststoffschweißen mittels Ultraschall verbunden werden. Hierzu wird die Sonotrode derart ausgebildet, dass über einen Bereich ein Metallschweißen und über einen anderen Bereich, der senkrecht zur tatsächlichen bzw. scheinbaren Schwingungsrichtung der Sonotrode verläuft, ein Kunststoffschweißen erfolgt.

Eine Vorrichtung der eingangs genannten Art zeichnet sich insbesondere dadurch aus, dass die Sonotrode zum Verschweißen der Leiter in verschiedenen Bereichen relativ entlang der Fläche des Trägers verfahrbar ist und dass der Träger entweder Durchbrechungen aufweist, auf die die Gegenelektrode ausrichtbar ist, oder zumindest bereichsweise als die Gegenelektrode ausgebildet ist. Dabei sollte die Sonotrode ein Torsionsschwinger, ein als Wippe ausgebildeter Längsschwinger, ein parallel geführter Längsschwinger oder ein Biegeschwinger sein.

Insbesondere ist vorgesehen, dass die Sonotrode ein Torsionsschwinger ist, dessen Längsachse geneigt oder senkrecht zu der die Flachleiter aufnehmenden Fläche des Trägers verläuft. Sonotrode und Gegenelektrode können dabei als Schweißzange ausgebildet sein. In diesem Fall bilden Sonotrode und Gegenelektrode eine Einheit, die zu den Flachleitern verstellbar ist.

Insbesondere ist jedoch vorgesehen, dass die Sonotrode wie der Torsionsschwinger von einem parallel zu der Fläche in zwei Koordinatenrichtungen verfahrbaren Portal ausgeht, zu dem die Sonotrode höhenverstellbar und/oder schwenkbar angeordnet ist Bevorzugterweise geht die Sonotrode von einem entlang eines Portals verstellbaren Querträger aus, entlang dem und zu dem die Sonotrode verstellbar ist.

Sofern der Träger für die Flachleiter nicht die Gegenelektrode ist, kann die Gegenelektrode mitlaufend zu der Sonotrode ausgebildet sein, so dass überaus präzise und in kurzer Zeit die Bereiche der Flachleiter anfahrbar sind, die untereinander verschweißt werden sollen.

Nach einem weiteren Vorschlag der Erfindung kann die Sonotrode über ein Mehrachsrobotersystem oder über einen Scara-Roboter verstellbar sein. Andere Möglichkeiten, um die Sonotrode auf die zu verbindenden bzw. zu verschweißenden elektrischen Leiter auszurichten, sind gleichfalls möglich.

Um die flächige Ersheckung der Schweißpunkte gezielt auf zu verschweißende Leiter auszurichten bzw. hohe Standzeiten zu erreichen, sieht eine eigenerfinderische Weiterbildung vor, dass die Sonotrode in Form eines Torsionsschwingers eine Sonotrodenkopffläche mit zumindest zwei Schweißfläche aufweist, die unterschiedliche Erstreckungen aufweisen können. Dabei ist die gewünschte Schweißfläche durch Drehen und/oder Kippen des Torsionsschwingers um seine Längsachse auf die zu verschweißenden Leiter ausrichtbar.

Insbesondere weist die Sonotrodenkopffläche einen Verlauf einer Oberfläche eines Konusses wie eines Kegels, eines Kegelstumpfes, einer Pyramide oder eines Pyramidenstumpfes auf. Auf der Oberfläche verteilt und beabstandet zur Längsachse des Torsionsschwingers können sodann verschiedene Schweißfläche ausgebildet sein, die durch Drehen bzw. Kippen der Sonotrode, also des Torsionsschwingers auf die Schweißbereiche ausrichtbar sind.

Ein weiterer hervorzuhebender Vorschlag der Erfindung sieht vor, dass die Sonotrode in Form eines Torsionsschwingers eine in ihrer Längsachsrichtung verlaufende Spitze zum

Durchstechen der zu verbindenden Flachleiter aufweist. Hierdurch ist ein mechanisches und insbesondere formschlüssiges Verbinden der Leiter möglich. Ergänzend kann sodann ein Verschweißen der Leiter mittels Ultraschall erfolgen. Hierzu weist die Gegenelektrode eine trichterförmige Aussparung auf, innerhalb der sich die durchstochenen Leiter erstrecken, um sodann ein Verschweißen zu ermöglichen.

Des Weiteren besteht die Möglichkeit, die Sonotrode, d.h. deren Kopf derart auszubilden, dass über einen Bereich ein Metallschweißen, also das Verbinden der Leiter untereinander, und über einen anderen Bereich die Außenisolationen der Flachleiter, also ein Kunststoffschweißen ermöglicht wird.

Das Positionieren der Sonotrode auf zu verschweißende Leiter kann mittels optischer Kontrollmittel erfolgen. Hierzu kann eine Bildverarbeitung und/oder ein optischer Strahl wie Laserstrahl zum Einsatz gelangen, der auf den Schweißbereich bzw. -punkt ausrichtbar ist, um das automatische oder manuelle Zuführen der Sonotrode bzw. deren Schweißfläche zu erleichtern.

Zusammen mit dem Verschweißen kann gleichzeitig eine Qualitätsüberwachung erfolgen, vorzugsweise wegabhängig zum Beispiel mit Servoantrieb, energie-, zeit- oder kraftabhängig. Auch ist ein Mehrstufenschweißen möglich. Insoweit wird auf hinlängliche Techniken verwiesen. Ferner besteht ohne Weiteres die Möglichkeit, zum Beispiel in Abhängigkeit von den zu verbindenden Materialien mit verschiedenen Frequenzen zu schweißen.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung von der Zeichnung zu entnehmenden bevorzugten Ausführungsbeispielen.

Es zeigen:
- Fig. 1: eine Draufsicht auf einen Überlappungsbereich von Flachleitern,
- Fig. 2: eine Prinzipdarstellung einer Vorrichtung zum Verschweißen von Flachleitern,
- Fig. 3: einen Ausschnitt einer weiteren Ausführungsform einer Vorrichtung zum Verschweißen von Flachleitern,
- Fig. 4: einen Abschnitt einer Sonotrode in Form eines Torsionsschwingers,
- Fig. 5: eine Prinzipdarstellung eines elektrische Leiter verbindenden Torsionsschwingers mit Gegenelektrode,
- Fig. 6: eine Prinzipdarstellung einer als Längsschwinger ausgebildeten Sonotrode und
- Fig. 7: eine Prinzipdarstellung einer als Biegeschwinger ausgebildeten Sonotrode.

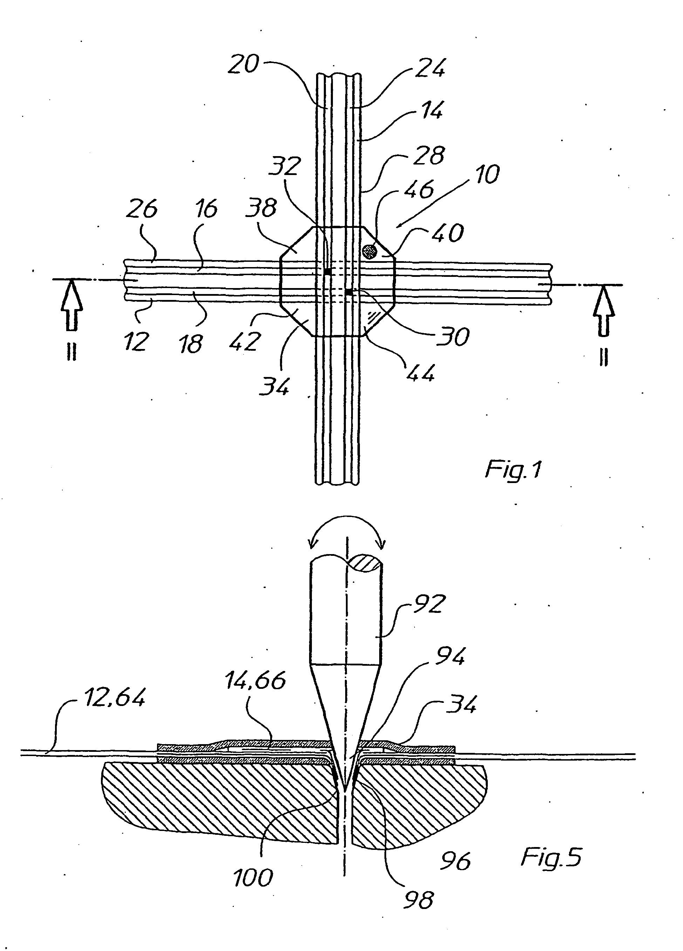

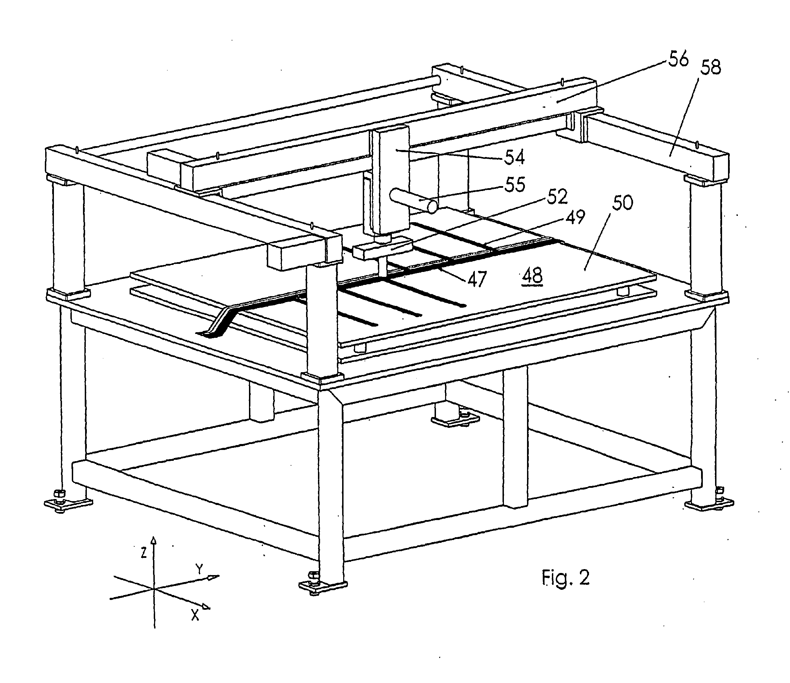

Fig. 1 ist rein prinzipiell ein Überlappungsbereich 10 zwischen Flachleitern 12 und 14 zu entnehmen. Dabei ist zeichnerisch dargestellt, dass sich die Flachleiter 12, 14 im rechten Winkel schneiden, ohne dass hierdurch eine Beschränkung der erfindungsgemäßen Lehre erfolgen soll. Vielmehr gilt diese für Überlappungsbereiche ganz allgemein, also Bereiche, in denen zumindest abschnittsweise Flachleiter aufeinanderliegen und deren Leiter elektrisch leitend verbunden werden. Auch ist in Fig. 1 nicht dargestellt, dass zur Realisierung der erfindungsgemäßen Lehre insbesondere vorgesehen ist, dass eine Vielzahl von Flachleitern in einer Ebene ausgebreitet zueinander ausgerichtet sind, um sodann im erforderlichen Umfang elektrische Leiter zu verbinden, wie prinzipiell aus der Fig. 2 ersichtlich ist.

Aus der Fig. 1 ist des Weiteren erkennbar, dass die Flachleiter 12, 14 in bekannter Weise elektrische Leiter 16, 18 bzw. 20, 24 wie flache Kupferbahnen aufweisen, die bahnenförmig ausgebildet sind. Die Leiter 16, 18, 20, 24 sind sodann von einer flächigen Außenisolierung 26, 28 umgeben. Dies kann durch Einbetten der Bahnen zum Beispiel in Polyesterfolien erfolgen.

Sollen Leiter von Flachleitern miteinander verbunden werden, so werden in den Überlappungsbereichen die Leiter bevorzugt freigelegt und sodann miteinander kontaktiert. Im Ausführungsbeispiel werden die elektrischen Leiter 18, 24 und 16, 20 an Kontaktstelle 30, 32 durch Schweißen verbunden. Hierzu wird die Isolierung 26, 28 in gewohnter Weise zum Beispiel durch Laser entfernt, um sodann die freigelegten Leiter miteinander zu verbinden. Bei bestimmten Anwendungen ist jedoch eine Kontaktierung mittels Ultraschallschweißung ohne vorheriges beidseitiges Abisolieren möglich.

Damit die Kontaktstellen auch starken mechanischen Belastungen standhalten, kann der Überlappungsbereich 10 von Abdeckungen umgeben werden, die sich mit Abschnitten 38, 40, 42, 44 außerhalb der Leiter 12, 14 erstrecken und durch Ultraschallschweißen miteinander verbunden werden. Hierdurch werden die Kontaktstellen 30, 32 mechanisch stabilisiert. Gleichzeitig geht jedoch die Flexibilität der Flachleiter 12, 14 an sich nicht verloren, da die flächigen Abdeckungen aus Kunststoffmaterial wie aus Schmelzkleber oder Kunststoffband mit Schmelzkleber bestehen und eine Dicke aufweisen können, die in etwa der der Flachleiter entspricht. Durch die geringe Höhe der Abdeckungen wird erkennbar die Bauhöhe der Flachleiter 12, 14 dem Grund nach nicht störend verändert.

Die Abdeckungen weisen bevorzugterweise eine rondenartige Form auf. Dabei können die zwischen den Leitern 12, 14 verlaufenden Abschnitte 38, 40, 42, 44 entsprechend der Darstellung der Fig. 1 umfangsseitig begradigt werden. Des Weiteren können die Abschnitte 38, 40, 42, 44 nach Montieren der Leiterbahnen 12, 14 zum Beispiel in einem Kraftfahrzeug als Befestigungen dienen. Ein entsprechender Befestigungspunkt ist in Fig. 1 mit dem Bezugszeichen 46 versehen.

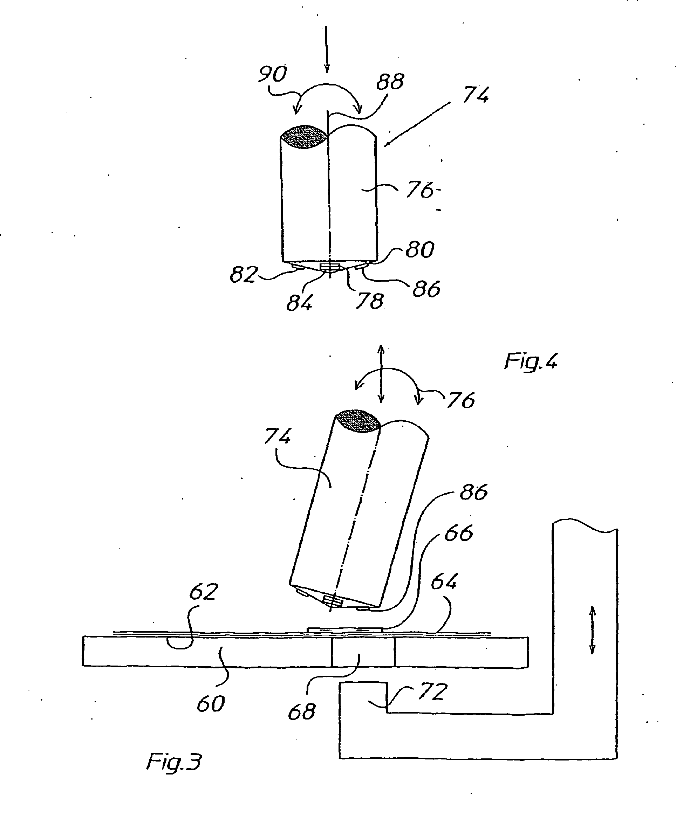

Um Flachleiter 47, 49 miteinander elektrisch leitend verbinden zu können, ist erfindungsgemäß vorgesehen, dass die Flachleiter 47, 49 auf einer Fläche 48 eines Trägers 50 positioniert werden, um sodann mittels Ultraschallschweißens elektrisch leitend verbunden zu werden. Hierzu muss eine entsprechende Sonotrode 52 auf die zu verbindenden Stellen ausgerichtet werden. Bei der Sonotrode 52 kann es sich um einen Torsionsschwinger handeln, der mit einem nicht näher dargestellten Konverter verbunden ist, um elektrische Schwingungen in Ultraschallschwingungen bestimmter Frequenz und Amplitude umzuwandeln. Der Konverter ist dabei in einem Gehäuse 54 angeordnet, das entlang einer Traverse 56 verstellbar ist, die wiederum entlang eines Portals 58 verfahrbar ist. Hierdurch ist die Möglichkeit gegeben, dass die Sonotrode 52 über die gesamte Fläche 48 verfahrbar ist, also jeden gewünschten Punkt ansteuern kann. Somit sind die in Fig. 2 eingezeichneten xy-Koordinaten abdeckbar. Des Weiteren ist das Gehäuse 54 mit der Sonotrode 52 sowohl in z-Richtung verstellbar, die wiederum um ihre Längsachse verschwenkbar ist, um gewünschte Schweißbereiche des Sonotrodenkopfes zu nutzen, wie dies anhand der Fig. 3 und 4 erläutert wird.

Die der Sonotrode 52 zugeordnete Gegenelektrode kann der Träger 50 selbst sein. Alternativ und anhand der Fig. 3 dargestellt kann ein Träger 60, auf dessen Oberfläche 62 Flachleiter 64, 66 zueinander positioniert werden, Durchbrechungen 68 aufweisen. Dabei werden fluchtend zu den Durchbrechungen die Bereiche der Flachleiter 64, 66 ausgerichtet, die untereinander verschweißt werden sollen. Sodann kann die Durchbrechung 68 von einer Gegenelektrode 72 durchsetzt werden, um die Flachleiter 64, 66 abzustützen. Gegenüberliegend wird im Ausführungsbeispiel ein Torsionsschwinger 74 auf den Verbindungsbereich abgesetzt und in Drehschwingung versetzt (Pfeil 76), um ein Metallschweißen durchzuführen.

Wie die Sonotrode 52 gemäß Fig. 2 bzw. eine entsprechende Sonotrode 74 in Fig. 4 verdeutlichen, weist die Sonotrode 74 einen zylinderischen Körper 76 mit einem kegelstumpfförmigen Kopf 78 auf, an dessen Außenfläche 80 mehrere Schweißflächen 82, 84, 86 gegebenenfalls voneinander abweichender Dimensionierungen ausgebildet sind, die auf die zu verschweißenden Bereiche der Flachleiter 64, 66 aufsetzbar sind, um sodann die elektrische Leiter der Flachleiter 64, 66 beim gleichzeitigen Abstützen dieser auf der Gegenelektrode 72 zu verschweißen. Um einen gewünschten Schweißbereich 82, 84, 86 des Sonotrodenkopfes auf einen Kontaktbereich auszurichten, ist es nur erforderlich, dass entweder die Sonotrode 74 um ihre Längsachse 88 gedreht und/oder verschwenkt wird (Doppelpfeil 90).

Um die Sonotrode 74 bzw. die Schweißfläche 82, 84, 86 auf den verschweißten Bereich positionsgenau auszurichten, kann ein optisches System wie Bildverarbeitungssystem genutzt werden. Auch besteht die Möglichkeit, die Sonotrode von Hand anzufahren, wobei der zu verschweißende Bereich zum Beispiel optisch mittels zum Beispiel eines Laserstrahls gekennzeichnet werden kann. Hierzu geht gemäß Fig. 2 von dem Gehäuse 54 ein Griff 55 aus.

Zu dem Ausführungsbeispiel der Fig. 3 ist anzumerken, dass die Sonotrode 74 und die Gegenelektrode 72 als Schweißzange ausgebildet sein können, so dass ein synchrones Bewegen erfolgt.

Sofern bei einer Portalbauweise, wie diese prinzipiell der Fig. 2 zu entnehmen ist, der Träger 52 nicht als Gegenelektrode ausgebildet ist, sondern entsprechend der Fig. 3 Durchbrechungen aufweist, auf die die Kontaktstellen ausgerichtet werden, so kann unterhalb der Fläche 48 synchron mit der Bewegung der Sonotrode 52 eine Gegenelektrode bzw. ein Amboss mitlaufen.

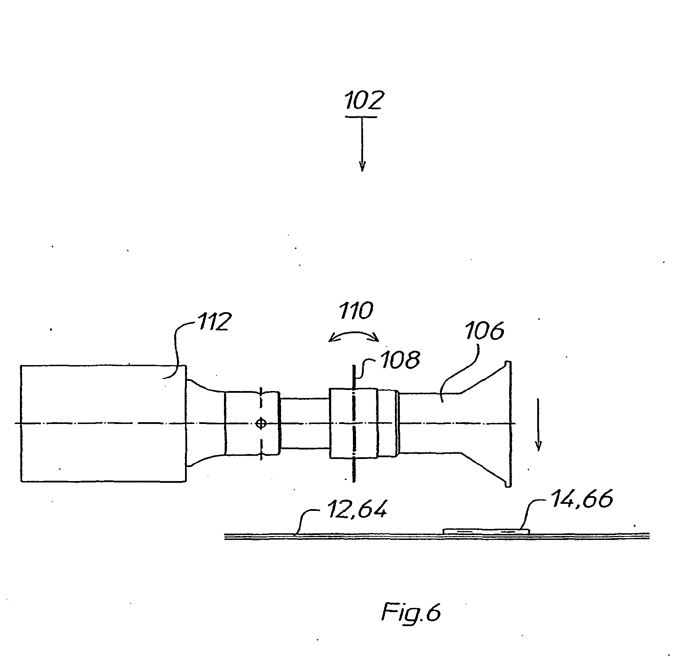

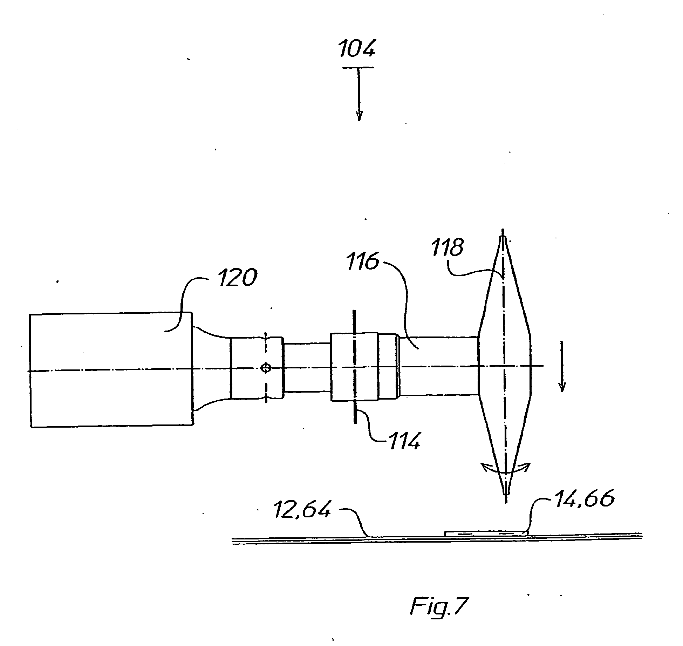

Ist anhand der Fig. 2 bis 4 das Verschweißen der Kontaktstellen von Leitern sich überlappender Flachleiter 12, 14, 47, 49, 64, 66 mittels Torsionsschwinger 52, 74 erläutert worden, so ist die erfindungsgemäße Lehre auch mit sonstigen aus der Ultraschallschweißtechnik bekannten Sonotroden wie einem Längsschwinger 102 (Fig. 6) oder einem Biegeschwinger 104 (Fig. 7) realisierbar. Dabei sind sowohl der Längsschwinger 102 als auch der Biegeschwinger 104 vorzugsweise in Art einer Wippe kippbar ausgebildet, um präzise auf einen gewünschten Schweißpunkt von sich überlappenden Leitern 12, 14, 64, 66 ausgerichtet zu werden. Dabei ist der Längsschwinger 102 in einem Schwingungsknoten 108 gelagert, um entsprechend dem Doppelpfeil 110 gekippt zu werden, um also auf die Schweißstelle abgesenkt zu werden. Dabei ist die Sonotrode 106 im Ausführungsbeispiel boosterlos mit einem Konverter 112 verbunden.

Selbstverständlich besteht auch die Möglichkeit, die Schwinger 102, 104 parallel zum Schweißpunkt zuzuführen.

Der Biegeschwinger 104 ist in Art einer Wippe in einem Bereich 114 eines Boosters 116 gelagert, der die Sonotrode 118 des Biegeschwingers 104 mit einem Konverter 120 verbindet. In Bezug auf den Aufbau bzw. die Funktionsweise des Längsschwingers 102 bzw. Biegeschwingers 104 wird auf hinreichend bekannte Techniken verwiesen, so dass auf diese nicht näher einzugehen ist.

Beim Verschweißen selbst kann eine Qualitätsüberwachung erfolgen. Dies kann wegabhängig zum Beispiel mit einem Servoantrieb und/oder energie-, zeit- oder kraftabhängig realisiert werden. Auch ist ein Mehrstufenschweißen möglich.

Ein Ausrichten der Sonotrode kann abweichend von den erläuterten Ausführungsbeispielen auch mittels eines Mehrachsrobotersystems oder eines Scara-Roboters erfolgen. Andere technische Realisierungen sind gleichfalls denkbar. Ausschlaggebend ist jedoch, dass die Sonotrode bzw. deren Schweißfläche überaus präzise auf zu verschweißende Bereiche ausrichtbar sein sollte. Gleichzeitig sollte eine optimale Zugänglichkeit zu der Schweißstelle gewährleistet sein. Dies wird insbesondere durch die Ausbildung eines Torsionsschwingers entsprechend den Ausfubrungsbeispielen der Fig. 3 und 4 ermöglicht.

Eine weitere Ausbildung der erfindungsgemäßen Lehre ergibt sich aus der Fig. 5. Dabei wird mittels eines Torsionsschwingers 92 nicht nur ein Verschweißen von zu verbindenden elektrischen Leitern von Flachleitern realisiert, sondern gleichzeitig ein mechanisches Verbinden dieser durch Durchstechen der Leiter selbst. Hierzu weist die Sonotrode 92 stirnflächenseitig eine Spitze 94 auf, die derart dimensioniert ist, dass zu verbindende Leiter quasi punktförmig durchstochen werden können. Hierdurch ergibt sich eine durch die Form der Spitze 94 vorgegebene kraterförmige Ausbildung der zu verbindenden Leiter. Dabei wird das Auseinanderbiegen der Leiter durch eine der Sonotrode 92 zugeordnete Gegenelektrode 96 begrenzt, die eine trompeten- oder trichterförmige Aussparung 98 aufweist, in die sich bereichsweise die Spitze 94 der Sonotrode 92 beim Durchstechen der Leiter erstreckt. Spitze 94 und Aussparung 98 sind demzufolge geometrisch einander angepasst. Dabei erfolgt ein Anlegen der Leiter an der Begrenzungsfläche 100 der Aussparung 98, so dass anschließend ein Verschweißen der Leiter mittels der von der Sonotrode 92 erzeugten Ultraschallenergie erfolgen kann. Die Begrenzungsfläche 100 der Aussparung 98 der Gegenelektrode 96 übt somit die Funktion des Ambosses aus. Folglich werden die Leiter nach dem Ausführungsbeispiel der Fig. 5 gepierced und mittels Ultraschalls verschweißt.

## Patentansprüche

1. Verfahren zum Verbinden von von Außenisolationen (26,28) umgebenen elektrischen Leitern (16, 18, 20, 24) von sich überlappenden Flachleitern (12, 14, 47, 49, 64, 66) mittels Ultraschallschwingungen erzeugender Sonotrode (52, 74, 92, 102, 104) und dieser zugeordneter Gegenelektrode (72), wobei auf einer zwischen der Sonotrode und der Gegenelektrode verlaufenden Fläche (48, 62) eines Trägers (50, 60) die zu verschweißenden Leiter angeordnet werden,
**dadurch gekennzeichnet,**
**dass** die Flachleiter (12, 14, 47, 49, 64, 66) verschiedenen Bereichen nacheinander verschweißt werden, dass die Sonotrode (52, 74, 92, 102, 104) und die verschiedenen Bereiche nacheinander aufeinander ausgerichtet werden und dass als Träger (50, 60) ein solcher verwendet wird, der zumindest bereichsweise als Gegenelektrode ausgebildet ist oder der in den Bereichen, in denen die Flachleiter verschweißt werden, Durchbrechungen (68) aufweist, auf die im erforderlichen Umfang die Gegenelektrode (72) ausgerichtet wird oder die im erforderlichen Umfang auf die Gegenelektrode ausgerichtet werden.

2. Verfahren nach Anspruch 1,
**dadurch gekennzeichnet,**
**dass** die Sonotrode nacheinander auf die verschiedenen zu verschweißenden Bereiche ausgerichtet wird.

3. Verfahren nach Anspruch 1 oder 2,
**dadurch gekennzeichnet,**
**dass** als Sonotrode eine solche verwendet wird, die als ein Torsionsschwinger, ein als Wippe gelagerter Längsschwinger, ein parallel geführter Längsschwinger oder als ein Biegeschwinger ausgebildet ist.

4. Verfahren nach zumindest einem der vorhergehenden Ansprüche,
**dadurch gekennzeichnet,**
**dass** die Sonotrode zur Erzeugung der zum Verschweißen der Leiter erforderlichen Ultraschallenergie in Torsionsschwingung versetzt wird, wobei die Sonotrode (76) mit ihrer Längsachse senkrecht oder geneigt zu der Fläche verläuft, auf der die zu verschweißenden Flachleiter angeordnet werden.

5. Verfahren nach zumindest einem der vorhergehenden Ansprüche,
**dadurch gekennzeichnet,**
**dass** die Leiter mittels der in Torsionsschwingung versetzten Sonotrode (92) sowohl mechanisch durchstochen als auch verschweißt werden.

6. Verfahren nach zumindest einem der vorhergehenden Ansprüche,
**dadurch gekennzeichnet,**
**dass** die Sonotrode auf zu verschweißende Leiter unter visueller Kontrolle mit Hilfe eines optischen Systems ausgerichtet wird.

7. Verfahren nach Anspruch 6,
**dadurch gekennzeichnet,**
**dass** die visuelle Kontrolle über eine Bildverarbeitung durchgeführt wird.

8. Verfahren nach zumindest einem der vorhergehenden Ansprüche,
**dadurch gekennzeichnet,**
**dass** zu verschweißender Bereich der Leiter optisch **gekennzeichnet** wird.

9. Vorrichtung zum Verbinden von von Außenisolationen (26, 28) umgebenen elektrischen Leitern (16, 18, 20, 24) von sich überlappenden Flachleitern (12, 14, 47, 49, 64, 66) mittels Ultraschallschwingungen erzeugender Sonotrode (52, 74, 92, 102, 104) und dieser zugeordneter Gegenelektrode (72), wobei auf einer zwischen der Sonotrode und der Gegenelektrode verlaufenden Fläche (48, 62) eines Trägers (50, 60) die zu verschweißenden Leiter anordbar sind,
**dadurch gekennzeichnet,**
**dass** die Sonotrode (52, 74, 92, 102, 104) zum Verschweißen der Leiter (16, 18, 20, 24) in verschiedenen Bereichen relativ entlang der Fläche (48, 62) des Trägers (50, 60) verfahrbar ist und dass der Träger entweder Durchbrechungen (68) aufweist, auf die die Gegenelektrode (72) ausrichtbar ist, oder zumindest bereichsweise als die Gegenelektrode ausgebildet ist.

10. Vorrichtung nach Anspruch 9,
**dadurch gekennzeichnet,**
**dass** die Sonotrode (52) ein Torsionsschwinger (74, 92), ein als Wippe ausgebildeter Längsschwinger (102), ein parallel geführter Längsschwinger oder ein Biegeschwinger (104) ist.

11. Vorrichtung nach Anspruch 10,
**dadurch gekennzeichnet,**
**dass** der Torsionsschwinger (74) mit seiner Längsachse (88) geneigt oder senkrecht zu der die Flachleiter abstützenden Fläche (68, 42) des Trägers (50, 60) verläuft.

12. Vorrichtung nach zumindest Anspruch 9,
**dadurch gekennzeichnet,**
**dass** die Sonotrode (74) und die Gegenelektrode (72) als Schweißzange ausgebildet sind.

13. Vorrichtung nach zumindest einem der vorhergehenden Ansprüch 9 bis 12,
**dadurch gekennzeichnet,**
**dass** die Sonotrode (52) von einem parallel zu der Fläche (48) in zwei Koordinatenrichtungen verfahrbaren Portal (56, 58) ausgeht, zu dem die Sonotrode höhenverstellbar und/oder schwenkbar angeordnet ist.

14. Vorrichtung nach zumindest einem der vorhergehenden Ansprüche 9 bis 13,
**dadurch gekennzeichnet,**
**dass** die Sonotrode (52) von einem entlang eines Portals (58) verstellbaren Querträger (56) ausgeht, entlang dem und zu dem die Sonotrode verstellbar bzw. schwenkbar ist.

15. Vorrichtung nach zumindest einem der vorhergehenden Ansprüche 9 bis 14,
**dadurch gekennzeichnet,**
**dass** die Sonotrode in Form eines Torsionsschwingers (74) eine Sonotrodenkopffläche (80) mit zumindest zwei Schweißflächen (82, 84, 86) aufweist.

16. Vorrichtung nach Anspruch 15,
**dadurch gekennzeichnet,**
**dass** gewünschte Schweißflächen (82, 84, 86) durch Drehen und/oder Kippen des Torsionsschwingers (74) auf die zu verschweißenden Leiter ausrichtbar ist.

17. Vorrichtung nach zumindest einem der vorhergehenden Ansprüch 15 oder 16,
**dadurch gekennzeichnet,**
**dass** die Sonotrodenkopffläche (80) Oberfläche eines Konusses wie eines Kegels, eine Kegelstumpfes, einer Pyramide oder eines Pyramidenstumpfes ist.

18. Vorrichtung nach zumindest einem der vorhergehenden Ansprüche 9 bis 17,
**dadurch gekennzeichnet,**
**dass** die Gegenelektrode (72) mitlaufend zu der Sonotrode (74) verstellbar ist.

19. Vorrichtung nach zumindest einem der vorhergehenden Ansprüche 9 bis 12 und 15 bis 18,
**dadurch gekennzeichnet,**
**dass** die Sonotrode über ein Mehrachs-Roboter-System oder einen SCARA-Roboter verstellbar ist.

20. Vorrichtung nach zumindest einem der vorhergehenden Ansprüche 9 bis 19,
**dadurch gekennzeichnet,**
**dass** die Sonotrode sowohl zum Metallschweißen als auch zum Kunststoffschweißen ausgebildet ist.

21. Vorrichtung nach zumindest einem der vorhergehenden Ansprüche 9 bis 14 und 18 bis 20,
**dadurch gekennzeichnet,**
**dass** die Sonotrode (92) in Form eines Torsionsschwingers eine in dessen Längsachsenrichtung verlaufende Spitze (94) zum Durchstechen der zu verbindenden Leiter aufweist.

22. Vorrichtung nach zumindest einem der vorhergehenden Ansprüche 9 bis 21,
**dadurch gekennzeichnet,**
**dass** die Sonotrode auf zu verschweißende Leiter mittels optischer Kontrollmittel positionierbar ist.

23. Vorrichtung nach zumindest einem der vorhergehenden Ansprüche 9 bis 22,
**dadurch gekennzeichnet,**
**dass** das Positionieren der Sonotrode auf zu verschweißende Leiter über eine Bildverarbeitung erfolgt.

24. Vorrichtung nach zumindest einem der vorhergehenden Ansprüche 9 bis 23,
**dadurch gekennzeichnet,**
**dass** zu verschweißender Bereich von Leitern mittels optischen Strahls wie Laserstrahls anzeigbar ist.

## Claims

1. A method for connection of electrical conductors (16, 18, 20, 24), surrounded by external insulators (26, 28), of overlapping flat conductors (12, 14, 47, 49, 64, 66) by means of a sonotrode (52, 74, 92, 102, 104) generating ultrasonic oscillations and a counter electrode (72) associated therewith, where the conductors to be welded are arranged on a surface (48, 62) of a carrier (50, 60) running between sonotrode and counter electrode,
**characterized in**
**that** the flat conductors (12, 14, 47, 49, 64, 66) are welded one after the other in various areas, that the sonotrode (52, 74, 92, 102, 104) and the various areas are consecutively aligned with one another, and that the carrier (50, 60) used is one that is designed at least in areas as a counter electrode or has in those areas in which the flat conductors are welded penetrations (68) with which the counter electrode (72) is aligned to the necessary extent or which is aligned with the counter electrode to the necessary extent.

2. Method according to Claim 1,
**characterized in**
**that** the sonotrode is aligned successively with the various areas to be welded.

3. Method according to Claim 1 or 2,
**characterized in**
**that** the sonotrode used is one that is designed as a torsion oscillator, a longitudinal oscillator mounted as a rocker, a parallel-guided longitudinal oscillator or a flexible oscillator.

4. Method according to at least one of the previous claims,
**characterized in**
**that** the sonotrode for generating the ultrasonic energy required for welding of the conductors is converted to torsion oscillation, where the longitudinal axis of the sonotrode (76) is vertical or oblique to the surface on which the flat conductors to be welded are arranged.

5. Method according to at least one of the previous claims,
**characterized in**
**that** the conductors are both mechanically pierced and welded by the sonotrode (92) converted to torsion oscillation.

6. Method according to at least one of the previous claims,
**characterized in**
**that** the sonotrode is aligned with the conductors to be welded under visual control with the aid of an optical system.

7. Method according to claim 6,
**characterized in**
**that** the visual check is performed with an image processing means.

8. Method according to at least one of the previous claims,
**characterized in**
**that** the area to be welded of the conductors is visually identified.

9. Device for connection of electrical conductors (16, 18, 20, 24), surrounded by external insulators (26, 28), of overlapping flat conductors (12, 14, 47, 49, 64, 66) by means of a sonotrode (52, 74, 92, 102, 104) generating ultrasonic oscillations and a counter electrode (72) associated therewith, where the conductors to be welded are placeable on a surface (48, 62) of a carrier (50, 60) running between the sonotrode and the counter electrode,
**characterized in**
**that** the sonotrode (52, 74, 92, 102, 104) for welding of the conductors (16, 18, 20, 24) is relatively movable along the surface (48, 62) of the carrier (50, 60) in various areas, and that the carrier either has penetrations (68) with which the counter electrode (72) can be aligned or is designed at least in areas as the counter electrode.

10. Device according to Claim 9,
**characterized in**
**that** the sonotrode (52) is a torsion oscillator (74, 92), a longitudinal oscillator (102) designed as a rocker, a parallel-guided longitudinal oscillator or a flexible oscillator (104).

11. Device according to Claim 10,
**characterized in**
**that** the the torsion oscillator (74) with its longitudinal axis (88) is oblique or vertical to the surface (68, 42) of the carrier (50, 60) supporting the flat conductors.

12. Device according to at least Claim 9,
**characterized in**
**that** the sonotrode (74) and the counter electrode (72) are designed as welding tongs.

13. Device according to at least one of the previous claims 9-12,
**characterized in**
**that** the sonotrode (52) origins from a gantry (56, 58) movable parallel to the surface (48) in two coordinate directions, to which gantry the sonotrode is height-adjustably and/or swivellably arranged.

14. Device according to at least one of the previous claims 9-13,
**characterized in**
**that** the sonotrode (52) origins from a cross-carrier (56) adjustable along a gantry (58), along which and relative to which the sonotrode is adjustable or swivellable.

15. Device according to at least one of the previous claims 9-14,
**characterized in**
**that** the sonotrode in the form of a torsion oscillator (74) has a sonotrode head surface (80) with at least two welding surfaces (82, 84, 86).

16. Device according to claim 15,
**characterized in**
**that** required welding surfaces (82, 84, 86) can be aligned with the conductors to be welded by rotation and/or tilting of the torsion oscillator (74).

17. Device according to at least one of the previous claims 15 or 16,
**characterized in**
**that** the sonotrode head surface (80) is surface of a conus such as a cone, a truncated cone, a pyramid or a truncated pyramid.

18. Device according to at least one of the previous claims 9-17,
**characterized in**
**that** the counter electrode (72) is adjustable synchronously with the sonotrode (74).

19. Device according to at least one of the previous claims 9-12 and 15-18,
**characterized in**
**that** the sonotrode is adjustable using a multiple-axis robot system or a SCARA robot.

20. Device according to at least one of the previous claims 9-19,
**characterized in**
**that** the sonotrode is designed both for metal welding and for plastic welding.

21. Device according to at least one of the previous claims 9-14 and 18-20,
**characterized in**
**that** the sonotrode (92) in the form of a torsion oscillator has a point (94) running in its longitudinal direction for piercing the conductors to be connected.

22. Device according to at least one of the previous claims 9-21,
**characterized in**
**that** the sonotrode is positionable on conductors to be welded using optical checking means.

23. Device according to at least one of the previous claims 9-22,
**characterized in**
**that** positioning of the sonotrode on conductors to be welded is achieved by an image processing means.

24. Device according to at least one of the previous claims 9-23,
**characterized in**
**that** the area of conductors to be welded is indicated by an optical beam such as a laser beam.

## Revendications

1. Procédé de jonction de conducteurs électriques (16, 18, 20, 24), enrobés d'une isolation externe (26, 28) et faisant partie de conducteurs en nappe (12, 14, 47, 49, 64, 66)
superposés, au moyen d'une sonotrode (52, 74, 92, 102, 104) produisant des vibrations ultrasonores et une contre-électrode (72) associée, sachant que les conducteurs à souder sont disposés sur une face (48, 62) d'un plateau-support (50, 60) s'étendant entre la sonotrode et la contre-électrode
**caractérisé en ce que**
les conducteurs en nappe (12, 14, 47, 49, 64, 66) sont consécutivement soudés les uns aux autres dans différentes zones, **en ce que** la sonotrode (52, 74, 92, 102, 104) et les différentes zones sont consécutivement alignées les unes sur les autres, et **en ce que** le plateau-support (50, 60) utilisé forme au moins dans certaines zones ladite contre-électrode ou présente des perçages (68) dans les zones où les conducteurs en nappe sont soudés, et dans lequel ladite contre-électrode (72) est alignée sur lesdits perçages ou dans lequel lesdits perçages sont alignés sur la contre-électrode, chaque fois dans la mesure du nécessaire.

2. Procédé selon la revendication 1
**caractérisé en ce que**
la sonotrode est consécutivement alignée sur les différentes zones à souder.

3. Procédé selon la revendication 1 ou 2
**caractérisé en ce que**
la sonotrode utilisée est un élément vibrant en torsion, ou vibrant en longitudinal sous forme de bascule, ou vibrant en longitudinal à guidage parallèle, ou vibrant en flexion.

4. Procédé selon au moins l'une des revendications précédentes
**caractérisé en ce que**
la sonotrode produisant l'énergie ultrasonore nécessaire au soudage des conducteurs est mise en vibrations en torsion et où l'axe longitudinal de ladite sonotrode (76) est
disposé de façon verticale ou inclinée par rapport à la face sur laquelle sont placés les conducteurs en nappe devant être soudés.

5. Procédé selon au moins l'une des revendications précédentes
**caractérisé en ce que**
les conducteurs sont aussi bien mécaniquement percés que soudés au moyen de la sonotrode (92) mise en vibrations en torsion.

6. Procédé selon au moins l'une des revendications précédentes
**caractérisé en ce que**
la sonotrode est alignée sur les conducteurs à souder au moyen d'un système optique et sous contrôle visuel.

7. Procédé selon la revendication 6
**caractérisé en ce que**
le contrôle visuel est effectué à l'aide d'un traitement d'images.

8. Procédé selon au moins l'une des revendications précédentes
**caractérisé en ce que**
la zone à souder des conducteurs est repérée de manière optique.

9. Procédé de jonction de conducteurs électriques (16, 18, 20, 24), enrobés d'une isolation externe (26, 28) et faisant partie de conducteurs en nappe (12, 14, 47, 49, 64, 66)
superposés, au moyen d'une sonotrode (52, 74, 92, 102, 104) produisant des vibrations ultrasonores et une contre-électrode (72) associée, sachant que les conducteurs à souder sont disposés sur une face (48, 62) d'un plateau-support (50, 60) s'étendant entre la sonotrode et la contre-électrode
**caractérisé en ce que**
la sonotrode (52, 74, 92, 102, 104) assurant le soudage des conducteurs (16, 18, 20, 24) est déplaçable dans différentes zones le long de la face (48, 62) du plateau-support (50, 60) et **en ce que** le plateau-support soit présente des perçages (68) sur lesquels la contre-électrode (72) peut être alignée, soit forme au moins dans certaines zones ladite contre-électrode.

10. Procédé selon la revendication 9
**caractérisé en ce que**
la sonotrode (52) est un élément vibrant en torsion (74, 92), ou vibrant en longitudinal (102) sous forme de bascule, ou vibrant en longitudinal à guidage parallèle, ou vibrant en flexion (104).

11. Procédé selon la revendication 10
**caractérisé en ce que**
l'axe longitudinal (88) de l'élément vibrant en torsion (74) est disposé de façon inclinée ou verticale par rapport à la face (68, 42) du plateau-support (50, 60) qui soutient les conducteurs en nappe.

12. Procédé selon la revendication 10
**caractérisé en ce que**
la sonotrode (74) et la contre-électrode (72) forment une pince à souder.

13. Procédé selon au moins l'une des revendications précédentes 9 à 12
**caractérisé en ce que**
la sonotrode (52) s'étend d'un portique (56, 58) déplaçable le long de deux coordonnées parallèles à la face (48) et sur lequel la sonotrode est disposée de manière réglable en hauteur et/ou pivotable.

14. Procédé selon au moins l'une des revendications précédentes 9 à 13
**caractérisé en ce que**
la sonotrode (52) s'étend d'une traverse (56) déplaçable le long du portique (58) et sur laquelle la sonotrode est disposée de manière réglable ou pivotable.

15. Procédé selon au moins l'une des revendications précédentes 9 à 14
**caractérisé en ce que**
la sonotrode en forme d'un élément vibrant en torsion (74) comporte une face frontale (80) dotée d'au moins deux surfaces de soudage (82, 84, 86).

16. Procédé selon la revendication 15
**caractérisé en ce que**
les surfaces de soudage (82, 84, 86) souhaitées peuvent être alignées sur les conducteurs à souder par rotation et/ou basculement de l'élément vibrant en torsion (74).

17. Procédé selon au moins l'une des revendications précédentes 15 ou 16
**caractérisé en ce que**
la face frontale (80) de la sonotrode est une surface conique, telle que celle d'un cône, d'un cône tronqué, d'une pyramide ou d'une pyramide tronquée.

18. Procédé selon au moins l'une des revendications précédentes 9 à 17
**caractérisé en ce que**
la contre-électrode (72) est ajustable en synchronisme avec la sonotrode (74).

19. Procédé selon au moins l'une des revendications précédentes 9 à 12 et 15 à 18
**caractérisé en ce que**
la sonotrode est ajustable au moyen d'un robot industriel à plusieurs axes ou d'un robot industriel SCARA.

20. Procédé selon au moins l'une des revendications précédentes 9 à 19
**caractérisé en ce que**
la sonotrode est aussi bien adaptée au soudage de métaux qu'au soudage de matières plastiques.

21. Procédé selon au moins l'une des revendications précédentes 9 à 14 et 18 à 20
**caractérisé en ce que**
la sonotrode (92) en forme d'un élément vibrant en torsion possède une pointe (94) s'étendant le long de l'axe longitudinal afin de percer les conducteurs à joindre.

22. Procédé selon au moins l'une des revendications précédentes 9 à 21
**caractérisé en ce que**
la sonotrode peut être positionnée sur les conducteurs à souder à l'aide de moyens de contrôle optiques.

23. Procédé selon au moins l'une des revendications précédentes 9 à 22
**caractérisé en ce que**
le positionnement de la sonotrode sur les conducteurs à souder est effectué par traitement d'images.

24. Procédé selon au moins l'une des revendications précédentes 9 à 23
**caractérisé en ce que**
la zone des conducteurs à souder peut être visualisée par rayons optiques tels que rayons laser.
